# EUROPÄISCHE PATENTSCHRIFT

(11) **EP 2 483 212 B1**
(45) Veröffentlichungstag und Bekanntmachung des Hinweises auf die Patenterteilung: **20.11.2013**
(21) Anmeldenummer: 10759886.4
(22) Anmeldetag: 28.09.2010
(51) Int. Cl.: C03B 23/20, C03B 32/00, C03C 3/06, C03B 19/14

(54) **ROHLING AUS TITAN-DOTIERTEM, HOCHKIESELSÄUREHALTIGEM GLAS FÜR EIN SPIEGELSUBSTRAT FÜR DEN EINSATZ IN DER EUV-LITHOGRAPHIE UND VERFAHREN FÜR SEINE HERSTELLUNG**
BLANK OF TITANIUM-DOPED GLASS WITH A HIGH SILICA CONTENT FOR A MIRROR SUBSTRATE FOR USE IN EUV LITHOGRAPHY AND METHOD FOR THE PRODUCTION THEREOF
ÉBAUCHE FAITE DE VERRE À TENEUR ÉLEVÉE EN SILICE, DOPÉE AU TITANE, POUR UN SUBSTRAT DE MIROIR POUR UNE UTILISATION EN LITHOGRAPHIE EUV, ET SON PROCÉDÉ DE FABRICATION

(30) Priorität: 30.09.2009 DE 102009043680
(43) Veröffentlichungstag der Anmeldung: 08.08.2012
(73) Patentinhaber: Heraeus Quarzglas GmbH & Co. KG, 63450 Hanau (DE)
(72) Erfinder: KUEHN, Bodo, 63571 Gelnhausen (DE)
(74) Vertreter: Staudt, Armin Walter
(86) Internationale Anmeldenummer: PCT/EP2010/064317
(87) Internationale Veröffentlichungsnummer: WO 2011/039159

(56) Entgegenhaltungen:
- DE-A1-102004 024 808
- US-A1- 2002 043 081
- US-A1- 2007 137 252
- US-A1- 2007 246 156

## Beschreibung

Die vorliegende Erfindung betrifft einen Rohling aus Titan-dotiertem, hochkieselsäurehaltigem Glas für ein Spiegelsubstrat für den Einsatz in der EUV-Lithographie, das einen zu verspiegelnden und beim bestimmungsgemäßen Einsatz des Spiegelsubstrats als hochbelastete Zone spezifizierten Oberflächenbereich aufweist, der eine Außenkontur hat.

Weiterhin betrifft die Erfindung ein Verfahren zur Herstellung eines derartigen Rohlings aus Titan-dotiertem, hochkieselsäurehaltigem Glas für ein Spiegelsubstrat für den Einsatz in der EUV-Lithographie.

### Stand der Technik

Bei der EUV Lithographie werden mittels mikrolithographischer Projektionsgeräte hochintegrierte Strukturen mit einer Linienbreite von weniger als 50 nm erzeugt. Dabei wird extrem-ultraviolettes Licht (EUV) - auch weiche Röntgenstrahlung genannt - mit Wellenlängen kleiner 15 nm eingesetzt. Die Projektionsgeräte sind mit Spiegelelementen ausgestattet, die entweder aus hochkieselsäurehaltigem und mit Titandioxid dotiertem Glas (im Folgenden auch als "Titan-dotiertes Glas" oder nur als "Glas" bezeichnet) oder aus einer Aluminiumsilikat-Glaskeramik bestehen und die mit einer reflektierenden Schicht versehen sind. Diese Werkstoffe zeichnen sich durch einen extrem niedrigen thermischen Ausdehnungskoeffizienten aus, so dass sie sich durch Erwärmung während des Belichtungsprozesses nicht verformen, was zu einer Verschlechterung der Abbildungsgüte führen würde.

Die thermische Ausdehnung des Spiegelelements wird bei Titan-dotiertem Glas im Wesentlichen durch die Konzentration und örtliche Verteilung des Dotierstoffs im Spiegelelement sowie die thermische Historie des Spiegelelement- Rohlings bestimmt.

Ein Glasrohling für ein Spiegelsubstrat der eingangs genannten Gattung und ein Verfahren zu seiner Herstellung sind aus der DE 10 2004 024 808 A bekannt. Es wird eine kreiszylinderförmige Spiegelsubstratplatte mit einem Durchmesser von 300 mm und einer Dicke von 40 mm beschrieben. Die Spiegelsubstratplatte besteht aus Titan-dotiertem synthetischem Glas mit sehr hoher Homogenität. Eine der Planflächen der Spiegelsubstratplatte wird ganz oder teilweise verspiegelt und liegt beim bestimmungsgemäßen Einsatz des Spiegelsubstrats senkrecht zur Hauptausbreitungsrichtung der weichen Röntgenstrahlung.

Der Oberflächenbereich um die Auftrefffläche der Röntgenstrahlung wird beim bestimmungsgemäßen Einsatz besonders belastet und ist hinsichtlich seiner Eignung und Eigenschaften besonders hoch spezifiziert. Dabei geht es im Wesentlichen um die Oberflächenqualität, um die Homogenität der Dotierstoffverteilung im hochbelasteten Bereich, um die räumliche Verteilung des thermischen Ausdehnungskoeffizienten und dessen Temperaturabhängigkeit, sowie um die so genannte ,zero crossing temperature', die diejenige Temperatur bezeichnet, bei der der thermische Ausdehnungskoeffizient gerade Null ist.

Eine hohe (Mikro-) Homogenität der Titan-Verteilung (also das Fehlen von Schichten) ermöglicht die Realisierung einer besonders hohen Oberflächengüte durch exaktere Polierbarkeit, beispielsweise durch chemisch-mechanisches Polieren (CMP). Die mittel- und langwellige Homogenität der Titan-Verteilung wirkt sich demgegenüber eher für einen verformungsarmen Einsatz des Spiegelelements beim Einsatz aus, indem durch Temperaturgradienten hervorgerufene Längenänderungen in den hochbelasteten Bereichen möglichst vermieden werden. In dem Zusammenhang ist zu beachten, dass die maximale (theoretische) Reflektivität eines EUV-Spiegelelements bei ca. 70% liegt, so dass mindestens 30% der Strahlungsenergie in Wärme umgesetzt werden. Aus Gründen der exakteren Polierbarkeit und der gleichförmigen Ausdehnung ist auch eine hohe Blasenfreiheit beziehungsweise -armut einzuhalten.

In einem Projektionsgerät sind eine Vielzahl derartiger Spiegelsubstrate enthalten, die nicht nur plane, sondern aus konvex oder konkav gekrümmte, verspiegelte Oberflächen mit einer an den spezifischen Einsatz angepassten Außenkontur aufweisen. Diese Außenkontur wird durch mechanische Bearbeitung eines Spiegelsubstrat-Rohlings, die typischerweise Schneid-, Schleif- und Polierschritte umfasst, erzeugt. Bei dieser mechanischen Bearbeitung werden Oberflächenbereiche aus dem Volumen des Spiegelsubstrat-Rohlings freigelegt, die daraufhin die zu verspiegelnde Oberfläche und insbesondere auch den Oberflächenbereich der hochbelasteten Zone bilden. Dabei können vorher im Volumen eingeschlossene Inhomogenitäten, wie Schichten und Blasen, an die Oberfläche gelangen, die Oberflächenqualität beeinträchtigen.

Um hohe Homogenität und Blasenfreiheit des Glases zu gewährleisten, wird in der DE 10 2004 024 808 A daher vorgeschlagen, einen mit Schichten enthaltenden Glas-Rohling anhand eines mehrstufigen Umformverfahrens zu homogenisieren. Mit diesem Homogenisierungsverfahren kann ein Spiegelsubstrat-Rohling aus Titan-dotiertem Glas erzeugt werden, das in drei Richtungen frei von Schichten und Schlieren ist und eine homogene Dotierstoffverteilung aufweist. Das Verfahren ist jedoch aufwändig und trägt zu den Herstellungskosten für derartige Spiegelsubstrate wesentlich bei.

Die US 2002/0043081 A1 beschreibt eine Vorform aus Titan-dotiertem, hochkieselsäurehaltigem Glas für die Herstellung einer Vielzahl asphärischer Spiegelsubstrat-Rohlinge für den Einsatz in der EUV-Lithographie. Die Vorform ist als Verbundkörper ausgeführt, wobei der zu verspiegelnde Bereich vollständig aus einer Frontplatte gebildet wird, die mit einem Stützkörper in Wabenform verschmolzen wird. Frontkörper und Stützkörper bestehen vorzugsweise aus Titan-dotiertem Glas mit beiderseits ähnlichem oder identischem thermischen Ausdehnungskoeffizienten. Die beiden Körper werden durch Verschmelzen, Verschweißen unter Einsatz einer Fritte oder Verkleben verbunden und anschließend wird die Oberseite des Frontkörpers zur Aufnahme der Spiegelschichten poliert.

Die einzelnen asphärischen Spiegelsubstrat-Rohlinge werden durch Ausschneiden von Teilstücken aus dem Verbundkörper erzeugt. Dabei kann es durch Spannungsrelaxation zu Verformungen der Teilstücke kommen, die sich auf die Oberflächenqualität nachteilig auswirken. Dieser Verformungseffekt wird durch die Wabenform des Stützkörpers reduziert.

Die Herstellung des wabenförmigen Stützkörpers aus Titan-dotiertem Glas ist jedoch sehr aufwändig und allein nicht ausreichend, den erwähnten Verformungseffekt durch Spannungsrelaxation zu verhindern. Ein Nachpolieren der ausgeschnittenen Teilstücke ist wegen deren asphärischer Form sehr schwierig, weil dabei leicht die Kanten rundgeschliffen werden.

### Technische Aufgabenstellung

Der Erfindung liegt daher die Aufgabe zugrunde, einen Spiegelsubstrat-Rohling aus synthetischem, hochkieselsäurehaltigem Glas für den Einsatz in der EUV-Lithographie bereit zu stellen, der kostengünstig herstellbar ist und der dennoch hohen Anforderungen bezüglich Homogenität, Blasen- und Schlierenfreiheit genügt.

Außerdem liegt der Erfindung die Aufgabe zugrunde, ein Verfahren zur Herstellung eines derartigen Spiegelsubstrat-Rohlings aus Titan-dotiertem, synthetischem Glas anzugeben.

Hinsichtlich des Verfahrens wird diese Aufgabe ausgehend von einem Verfahren der eingangs genannten Gattung durch folgende Verfahrensschritte gelöst:
(a) Erzeugen eines Frontkörpers aus Titan-dotiertem Glas hoher Homogenität mit einem Volumen "V1" und mit Abmessungen, die die Außenkontur mit Übermaß umschließen,
(b) Erzeugen eines Stützkörpers aus Titan-dotiertem Glas mit einem Volumen "V2", der als monolithischer Glasblock mit geringerer Homogenität als der Frontkörper ausgebildet ist
(c) Verbinden von Frontkörper und Stützkörper unter Bildung eines Verbundkörpers, und
(d) Bearbeitung des Verbundkörpers zum Spiegelsubstrat-Rohling,
wobei das Erzeugen des Frontkörpers einen Homogenisierungsprozess umfasst, der ein Verdrillen eines durch Flammenhydrolyse einer siliziumhaltigen Verbindung erhaltenen stangenförmigen Ausgangskörpers aus Titan-dotiertem Glas zu einem Frontkörperrohling umfasst, wobei der Ausgangskörper beim Umformen zwischen zwei Halterungen gehalten, zonenweise auf Schmelztemperatur gebracht und dabei die erhitzte Zone durch Relativbewegung der beiden Halterungen zueinander unter Ausbildung eines im Wesentlichen zylinderförmigen Drillkörpers durchgearbeitet wird.

Der Erfindung liegt die Erkenntnis zugrunde, dass im Gegensatz zur Mikrolithographie im ultravioletten Wellenlängenbereich, bei der Projektionssysteme mit optischen Bauteilen für den Durchlichtbetrieb eingesetzt werden, die bei der EUV-Lithographie eingesetzten Spiegelelemente keine vollkommene Homogenität über die gesamte Dicke des Spiegelelements erfordern, sondern nur über eine Teildicke. Diese Teildicke richtet sich nach der Außenkontur des fertigen Spiegelelements in seiner hochbelasteten Zone. Denn bei der mechanischen Bearbeitung des Spiegelsubstrat-Rohlings zum Erzeugen der Außenkontur wird nur in einem durch die Abmessungen der herzustellenden Außenkontur vorgegebenen Volumenbereich neue Oberfläche freigelegt. Es ist wichtig, dass das Glas in diesem Volumenbereich hohe Homogenität und Blasenfreiheit aufweist, wohingegen diese Anforderungen in den übrigen Volumenbereichen des Spiegelsubstrats geringer sind. Derjenige Volumenanteil an synthetischem Glas, der besonders hohen Homogenitätsanforderungen genügen muss, wird im Folgenden auch als "hochspezifizierter Volumenanteil" bezeichnet.

Gemäß der Erfindung wird ein Spiegelsubstrat-Rohling erzeugt, der in Form eines Verbundes aus mehreren Bauteilen, umfassend einen Stützkörper und einen Frontkörper, vorliegt. Die Herstellung des Verbundkörpers dient jedoch nicht einer Produktverbesserung, wie im oben erläuterten Stand der Technik, sondern einer Kostenreduzierung bei gleicher oder sogar leicht geringerer Performance als bei einem monolithischen Spiegelsubstrat-Rohling.

Der Frontkörper stellt mindestens das Glas für den "hochspezifizierten Volumenanteil" und ein gewisses Übermaß bereit. Das Glas des Frontkörpers genügt hohen Anforderungen an die Homogenität der Dotierstoff-Verteilung und an die Blasenfreiheit, um so eine exaktere Polierbarkeit der zu verspiegelnden Oberfläche sowie eine gleichförmig geringe Ausdehnung im hochbelasteten Volumenbereich des Spiegelelements zu gewährleisten. Diesen Qualitätsanforderungen an das Glas des Frontkörpers genügt ein Homogenisierungsprozess, der ein Verdrillen eines durch Flammenhydrolyse einer siliziumhaltigen Verbindung erhaltenen stangenförmigen Ausgangskörpers zu einem Frontkörperrohling umfasst, wobei der Ausgangskörper beim Umformen zwischen zwei Halterungen gehalten, zonenweise auf Schmelztemperatur gebracht und dabei die erhitzte Zone durch Relativbewegung der beiden Halterungen zueinander unter Ausbildung eines im Wesentlichen zylinderförmigen Drillkörpers durchgearbeitet wird.

Das Durcharbeiten (Verdrillen) des stangenförmigen Ausgangskörpers dient in erster Linie zur Beseitigung von Schlieren und Schichten im Glas, die sich auch aufgrund einer inhomogenen Massen- und Dotierstofferteilung ergeben. Das Ergebnis dieses Homogenisierungsprozesses ist ein Rohling aus homogenem, hochwertigen Glas, aus dem mindestens ein Frontkörper, vorzugsweise jedoch eine Vielzahl von Frontkörpern, erzeugt werden können.

Der Stützkörper liegt als einfacher, monolithischer Glasblock vor, der aus einem geringerwertigen Glas besteht, das insbesondere geringere Anforderungen an die Homogenität der Dotierstoffverteilung und an die Blasenfreiheit als bei dem höherwertigen Glas des Frontkörpers erfüllt. Auch die Anforderungen an andere, für die Anwendung als EUV-Spiegelsubstrat relevante Größen, nämlich an die räumliche Verteilung des thermischen Ausdehnungskoeffizienten und dessen Temperaturabhängigkeit, sowie an die ,zero crossing temperature' können im Stützkörper relaxiert werden, da hier die thermische Belastung in Folge der Strahlungsabsorption geringer ist als im Frontkörper.

Dadurch ergeben sich geringere Fertigungskosten für das Glas des Stützkörpers und damit eine Kostenersparnis gegenüber einem Spiegelsubstrat-Rohling, der vollständig aus hochwertigem Glas oder aus einem Verbundkörper aus hochwertigem Frontkörper und einem Stützkörper in Wabenstruktur besteht.

Der Unterschied in der Homogenität zwischen Front- und Stützkörper zeigt sich in der räumlichen Dotierstoffverteilung, die sich insbesondere in Form von Schichten und Schlieren äußert, und die zu Brechzahlinhomogenitäten und einer räumlich inhomogenen Verteilung des thermischen Ausdehnungskoeffizienten führt. Die Charakterisierung der Homogenität der Gläser erfolgt auf Basis der Anzahl an Schlieren pro Volumeneinheit. Schlieren entstehen durch lokale Variationen in der Zusammensetzung. Sie können mittels eine Mikrosonde quantitativ erfasst werden, die Unterschiede in der Zusammensetzung misst, die wiederum mit Unterschieden im thermischen Ausdehnungskoeffizienten bis in den Bereich weniger ppb/°C korrelieren. Die Angabe erfolgt als quadratischer Mittelwert (rms-Wert) in der Einheit MPa. Die Methode ist beispielsweise in EP 2 211 232 A1 beschrieben. Das Glas der Frontkörpers zeigt in diesem Sinne eine höhere Homogenität und damit einen kleineren rms-Wert als das Glas des Stützkörpers. Grundsätzlich hat hochkieselsäurehaltiges Titan-dotiertes Glas, das nicht oder nur in einer Richtung homogenisiert ist, einen geringeren Homogenisierungsgrad als hochkieselsäurehaltiges Titan-dotiertes Glas, das in allen Raumrichtungen homogenisiert ist.

Stützkörper und Frontkörper bestehen aus Glas das mit Titandioxid dotiert ist. Zusätzlich können anderer Dotierstoffe enthalten sein, wie etwa Fluor. Das Glas des Stützkörper hat idealerweise die nominal gleiche Zusammensetzung wie das Glas des Frontkörpers.

Das Verbinden von Frontkörper und Stützkörper kann ohne nennenswerte Verformung dieser Teile erfolgen (beispielsweise durch Schweißen oder durch Fügen unter Einsatz einer arteigenen Fügemasse aus Titan-dotiertem Glas) oder es geht mit einer Verformung der Teile einher. Auch ein bereits hergestellter Verbund aus Frontkörper und Stützkörper kann noch einem Verformungsprozess unterzogen werden.

Die Bearbeitung des Verbundkörpers zum Spiegelsubstrat-Rohling kann beispielsweise eine mechanische Bearbeitung, eine Heißverformung und/oder eine thermische Behandlung des Verbundkörpers umfassen. Er weist in der Regel noch nicht die Außenkontur der zu verspiegelnden Oberfläche auf. Um diese zu erzeugen, wird der Spiegelsubstrat-Rohling mechanisch zum Spiegelsubstrat bearbeitet. Dabei werden in der Regel konkav oder konvex gekrümmte Oberflächenbereiche erzeugt. Die Qualität des dabei bearbeiteten Volumens des Spiegelsubstrat-Rohlings ist maßgeblich für die Qualität der freigelegten Oberfläche. Beispielsweise darf das bearbeitete Volumen keine Blasen oder Schichten enthalten, da diese durch die Abtragung bei der mechanischen Bearbeitung an der Oberfläche zu liegen kommen und die Oberflächenqualität beeinträchtigen können. Der Frontkörper ist so bemessen, dass die Abtragtiefe bei der mechanischen Bearbeitung zur Herstellung der Außenkontur an jedem Ort geringer ist als die dort vorhandene Abmessung des Frontkörpers. Demnach wird die Oberfläche in der hochbelasteten Zone nach Abschluss der mechanischen Bearbeitung ausschließlich aus Glas des homogenen Frontkörpers gebildet. Dadurch ist auch eine hohe Oberflächenqualität in der hochbelasteten Zone gewährleistet.

Der Einsatz des ohne großen Aufwand herzustellenden, monolithischen Stützkörpers senkt zwar die Fertigungskosten für den Spiegelsubstrat-Rohling, jedoch unter Inkaufnahme von Nachteilen bezüglich der Performance.

Vorzugsweise wird der zylinderförmige Drillkörper einem weiteren Homogenisierungsprozess durch Verdrillen unterzogen und zu einem in drei Richtungen homogenisierten Drillkörper umgeformt.

Es hat sich bewährt, wenn das Erzeugen des Frontkörpers ergänzend ein Umformen eines zylinderförmigen Ausgangskörpers durch Erweichen und Ausfließenlassen in eine beheizte Form umfasst, in die das Glas unter Einwirkung einer Kraft in Querrichtung zur Zylinder- -Längsachse unter Bildung eines homogenisierten Ausgangskörpers ausfließt. Aus dem so homogenisierten Glas wird ein Formkörper, vorzugsweise mehrere Frontkörper, ausgeschnitten.

Das Ausfließenlassen eines zylinderförmigen Ausgangskörpers aus Glas in eine beheizte Form ist der DE 42 04 406 A1 beschrieben. Dieses Umformen führt ebenfalls zu einer Homogenisierung des Glases bis zu einer Schlieren- und Schichtenfreiheit in drei Richtungen. Auch etwaige Restblasen werden dabei verkleinert. Bei der auf den Ausgangskörper einwirkenden Kraft handelt es sich beispielsweise um die Schwerkraft aufgrund des eigenen Gewichts des Ausgangskörpers, optional ergänzt durch ein auf dem Ausgangskörper lastendes Zusatzgewicht und/oder einen auf den Ausgangskörper einwirkenden Druck. Bei dem Ausgangskörper handelt es sich beispielsweise um einen noch nicht vollständig homogenisierten Drillkörper.

Vorzugsweise wird mindestens ein Frontkörper, vorzugsweise mehrere Frontkörper durch Schneiden aus dem Drillkörper, beziehungsweise aus dem homogenisierten Drillkörper, beziehungsweise aus dem homogenisierten Ausgangskörper, erhalten.

Ergänzend dazu umfasst das Erzeugen des Frontkörpers die Herstellung einer Vorform aus synthetischem Glas sowie einen Verfahrensschritt der Selektion, bei dem aus der Vorform ein Teilstück hoher Qualität hinsichtlich Blasenfreiheit und Homogenität der Dotierstoffverteilung ausgewählt und daraus der Frontkörper ausgeschnitten wird.

Hierbei wird der Frontkörper durch Selektion geeigneter Volumenbereiche einer großvolumigen - in der Regel zylinderförmig - Glas-Vorform und Ausschneiden dieser Volumenbereiche erzeugt. Die nicht für die Erzeugung des Formkörpers geeigneten Volumenbereiche der großvolumigen Vorform können für die Erzeugung des Stützkörpers verwendet werden.

Das Glas für den Stützkörper wird entweder in einem anderen Prozess erzeugt, bei dem der Aufwand zur Homogenisierung geringer ist als beim Glas für den Frontkörper, oder das Glas des Stützkörpers wird anhand des gleichen Prozesses erzeugt wie das Glas des Frontkörpers. Im zuletzt genannten Fall wird in der Regel eine großvolumige Vorform aus Glas erhalten, aus der Volumenbereiche geringerer Qualität und Homogenität identifiziert und als Glas für den Stützkörper aussortiert werden können.

Insbesondere umfasst das Erzeugen des Stützkörpers vorzugsweise ein Homogenisieren eines durch Flammenhydrolyse einer siliziumhaltigen Verbindung erhaltenen stangenförmigen Stützkörper-Ausgangskörper zu einem Drillkörper, wobei der Stützkörper-Ausgangskörper beim Umformen zwischen zwei Halterungen gehalten, zonenweise auf Schmelztemperatur gebracht und dabei die erhitzte Zone durch Relativbewegung der beiden Halterungen zueinander unter Ausbildung eines im Wesentlichen zylinderförmigen Drillkörpers durchgearbeitet wird, wobei der Stützkörper aus dem Glas des Drillkörpers erhalten wird.

Es hat sich besonders bewährt, wenn das Verbinden gemäß Verfahrensschritt (c) einen Verbindungsschritt umfasst, bei dem eine plane Kontaktfläche des Frontkörpers und eine plane Kontaktfläche des Stützkörpers durch Ansprengen zusammengefügt und miteinander verschweißt werden.

Der Vorgang des Ansprengens ermöglicht ein blasenfreies Zusammenfügen von Stützkörper und Frontkörper. Diese liegen dabei mit jeweils plan polierten Kontaktflächen aneinander, was ein blasenfreies Verschweißen von Frontkörper und Stützkörper ohne nennenswerte Verformung erleichtert. Das Verschweißen erfolgt beispielsweise durch lokales Erhitzen und Erweichen im Bereich der Kontaktflächen mittels Laser, Plasmaflamme oder Brenngasflamme. Vorzugsweise erfolgt das Erweichen der Kontaktflächen jedoch in einem Ofen. Dabei wird die Anordnung aus Stützkörper und Frontkörper vollständig in einen Ofen eingebracht und erhitzt. Dadurch wird die reproduzierbare Herstellung einer fehlerfreien Verbindung erleichtert.

Alternativ dazu hat sich auch eine Verfahrensweise zur Herstellung der Verbindung zwischen Stützkörper und Formkörper gemäß Verfahrensschritt (c) bewährt, die einen Verbindungsschritt umfasst, bei dem der auf dem Stützkörper aufliegende Frontkörper in einem Ofen erweicht und mit diesem zusammen verformt wird und dabei mindestens teilweise in den Stützkörper einsinkt.

Bei dieser Verfahrensweise geht das Erzeugen eines Schmelzverbundes zwischen Stützkörper und Frontkörper mit einer plastischen Verformung der aufeinander liegenden Körper zum Verbundkörper einher. Die Verformung erfährt dabei im Wesentlichen das Glas des unten liegenden Stützkörpers, das dabei gleichzeitig erstmals oder zusätzlich homogenisiert wird. Die Verformung erfolgt vorzugsweise durch Erweichen und Ausfließenlassen in eine beheizte Form, wie oben für das Homogenisieren eines Ausgangskörpers aus Glas bereits näher erläutert.

Die beheizte Form gibt dabei die seitlichen Abmessungen des nach dem Verformen resultierenden Verbundkörpers vor. Der Frontkörper sackt dabei teilweise in das erweichte Glas des Stützkörpers ein. Die danach resultierende Massenverteilung des am Stützkörper angeschmolzenen Frontkörpers kann durch Versuche festgestellt oder durch Simulation bestimmt werden.

Diese Verfahrensweise des "Einsackenlassens" des Frontkörpers in eine weiche Stützkörpermasse hat den Vorteil, dass Endposition und -geometrie des Fronkörpers vergleichsweise genau vorherbestimmt werden können. Es wird eine innige und blasenarme Kontaktfläche erhalten und gleichzeitig wird eine geringere Einsatzmasse für den Frontkörper benötigt als bei Verbindungsmethoden mit großen Formänderungen, die in der Regel mehr Frontkörpermasse benötigen als eigentlich rechnerisch benötigt würden. Im fertigen Verbundkörper bildet der ursprüngliche Frontkörper einen Frontkörperbereich, der mindestens zum Teil in einen Stützkörperbereich eingebettet ist, also seitlich fixiert ist. Auf diese Weise ergibt sich ein fest gefügter Verbund, bei dem die Gefahr einer Delamination auch bei der mechanischen Bearbeitung verringert ist.

Bei einer weiteren, gleichermaßen geeigneten Verfahrensweise zur Herstellung des Verbundes zwischen Frontkörper und Stützkörper gemäß Verfahrensschritt (c) ist ein Verbindungsschritt vorgesehen, bei dem eine Kontaktfläche des Frontkörpers und eine Kontaktfläche des Stützkörpers erweicht und gegeneinander gepresst werden, wobei mindestens eine der Kontaktflächen eine nach außen gewölbte Oberfläche hat.

Hierbei werden Frontkörper und Stützkörper - vorzugsweise in Block- oder Stangenform - mit ihren jeweiligen Stirnseiten zusammengepresst und gleichzeitig erweicht, so dass wobei gleichzeitig die Kontaktflächen miteinander verschmolzen werden. Das Verschmelzen geschieht beispielsweise auf einer drehbankähnlichen Vorrichtung, mittels der Frontkörper und Stützkörper um eine gemeinsame Rotationsachse rotierbar und in Richtung der Rotationsachse axial verschiebbar sind. Um den Einschluss von Blasen zu vermeiden, hat mindestens eine der Kontaktflächen, vorzugsweise beide Kontaktflächen, eine nach außen gewölbte Oberfläche, so dass sich bei Kontakt eine im Wesentlichen punktförmige (und nicht großflächige) Berührungsfläche ergibt, die sich beim weiteren Zusammenpressen radial nach außen ausbreitet. Im einfachsten Fall sind die gewölbten Kontaktflächen spitz oder kegelförmig ausgebildet. Der so erzeugte Schmelzverbundkörper kann anschließend zwecks weiterer Homogenisierung einem Heißverformungsprozess unterzogen werden, wodurch die endgültige Geometrie des Verbundkörpers erhalten wird.

Es hat sich auch bewährt, wenn der Verbundkörper getempert wird.

Die Temperbehandlung dient dazu, etwaige Spannungen abzubauen, die bei der Herstellung der Fügeverbindung von Stützkörper und Frontkörper entstanden sein können. Derartige Spannungen können bei einem anschließenden Materialabtrag zu einer Deformation des Rohlings führen, und sie können sich auch auf die Politur störend auswirken. Ob ein Tempern tatsächlich notwendig ist, hängt von der Temperaturführung während des Verbindens gemäß Verfahrensschritt (c) und insbesondere beim Abkühlen des erzeugten Verbundes ab. Die Temperbehandlung umfasst gegebenenfalls einen oder mehrere Heißbehandlungsschritte. Die Ausbildung der Schmelzverbindung gemäß Verfahrensschritt (c) und die Temperbehandlung werden in einem Arbeitsgang oder in separaten Arbeitsgängen ausgeführt.

Die Ersparnis an Fertigungskosten ist umso größer, je kleiner der Volumenanteil des Frontkörpers am Spiegelsubstrat-Rohling ist. Das Volumen "V1" des Frontkörpers ist daher vorzugsweise so klein wie möglich und nur so groß wie nötig, um eine vollständige Modellierung der Außenkontur im hochbelasteten Bereich des Spiegelsubstrats zu ermöglichen. Aus Sicherheitserwägungen weist der Frontkörper jedoch ein gewisses Übermaß gegenüber dem Mindestmaß auf. Vorteilhafterweise ist das Volumen "V2" dabei mindestens doppelt so groß, besonders bevorzugt mindestens dreimal so groß wie "V1".

Hinsichtlich des Rohlings aus Titan-dotiertem Glas für ein Spiegelsubstrat für den Einsatz in der EUV-Lithographie wird die oben angegebene Aufgabe ausgehend von einem Rohling der eingangs genannten Gattung dadurch gelöst, dass der Rohling als Schmelzverbundkörper vorliegt, der einen Frontkörperbereich aus Titan-dotiertem Glas hoher Homogenität mit einem Volumen "V1" und mit Abmessungen, die die Außenkontur mit Übermaß umschließen, sowie einen Stützkörperbereich aus Titan-dotiertem Glas mit einem Volumen "V2" umfasst, bei dem der Stützkörperbereich als monolithischer Glasblock mit geringerer Homogenität als der Frontkörperbereich ausgebildet ist.

Der Erfindung liegt die Erkenntnis zugrunde, dass im Gegensatz zur Mikrolithographie im ultravioletten Wellenlängenbereich, bei der Projektionssysteme mit optischen Bauteilen für den Durchlichtbetrieb eingesetzt werden, die bei der EUV-Lithographie eingesetzten Spiegelelemente keine vollkommene Homogenität über die gesamte Dicke des Spiegelelements erfordern, sondern nur über eine Teildicke. Diese Teildicke richtet sich nach der Außenkontur des fertigen Spiegelelements in seiner hochbelasteten Zone. Denn bei der mechanischen Bearbeitung des Spiegelsubstrat-Rohlings zum Erzeugen der Außenkontur wird nur in einem durch die Abmessungen der herzustellenden Außenkontur vorgegebenen Volumenbereich neue Oberfläche freigelegt. Es ist wichtig, dass das Glas in diesem Volumenbereich hohe Homogenität und Blasenfreiheit aufweist, wohingegen diese Anforderungen in den übrigen Volumenbereichen des Spiegelsubstrats geringer sind. Derjenige Volumenanteil an synthetischem Glas, der besonders hohen Homogenitätsanforderungen genügen muss, wird im Folgenden auch als "hochspezifizierter Volumenanteil" bezeichnet.

Gemäß der Erfindung liegt der Spiegelsubstrat-Rohling in Form eines Fügeverbundes aus mehreren Bauteilen vor, die einen Stützkörperbereich und einen

Frontkörperbereich bilden. Der Frontkörperbereich stellt mindestens das Glas für den "hochspezifizierten Volumenanteil" und ein gewisses Übermaß bereit. Das Glas des Frontkörperbereichs genügt hohen Anforderungen an die Homogenität der Dotierstoff-Verteilung und an die Blasenfreiheit, um so eine exaktere Polierbarkeit der zu verspiegelnden Oberfläche sowie eine gleichförmig geringe Ausdehnung im hochbelasteten Volumenbereich des Spiegelelements zu gewährleisten.

Der Stützkörperbereich liegt als einfacher, monolithischer Glasblock vor, bestehend aus einem geringerwertigen Glas, mit geringeren Anforderungen an die Homogenität der Dotierstoffverteilung und die Blasenfreiheit als bei dem höherwertigen Glas des Frontkörperbereichs. Dadurch ergeben sich geringere Fertigungskosten für das Glas des Stützkörperbereichs und damit eine Kostenersparnis gegenüber einem Spiegelsubstrat-Rohling, der vollständig aus hochwertigem Glas oder aus einem Verbundkörper aus hochwertigem Frontkörper und einem Stützkörper in Wabenstruktur besteht. Das Glas des Stützkörperbereichs kann sich auch in anderen Eigenschaften als der Homogenität vom Glas des Frontkörpers unterscheiden.

Bei der mechanischen Bearbeitung des Spiegelsubstrat-Rohlings zwecks Ausbildung der Außenkontur der zu verspiegelnden Oberfläche werden in der Regel konkav oder konvex gekrümmte Oberflächenbereiche erzeugt. Die Qualität des dabei bearbeiteten Volumens des Spiegelsubstrat-Rohlings ist maßgeblich für die Qualität der freigelegten Oberfläche. Insbesondere darf das bearbeitete Volumen keine Blasen enthalten, da diese durch die Abtragung bei der mechanischen Bearbeitung an der Oberfläche zu liegen kommen und die Oberflächenqualität beeinträchtigen können. Der Frontkörperbereich ist daher so bemessen, dass die Abtragtiefe bei der mechanischen Modellierung der Außenkontur an jedem Ort geringer ist als die dort vorhandene Abmessung des Frontkörperbereichs. Demnach wird die Oberfläche in der hochbelasteten Zone nach Abschluss der mechanischen Bearbeitung ausschließlich aus Glas des homogenen Frontkörpers gebildet. Dadurch ist auch eine hohe Oberflächenqualität in der hochbelasteten Zone gewährleistet.

Stützkörperbereich und Frontkörperbereich bestehen aus Glas das mit Titandioxid dotiert ist. Zusätzlich können anderer Dotierstoffe enthalten sein, wie etwa Fluor.

Der erfindungsgemäße Rohling wird vorzugsweise anhand des oben erörterten Verfahrens hergestellt, indem ein Frontkörper und ein Stützkörper miteinander verbunden werden.

Es hat sich bewährt, wenn der Frontkörperbereich aus einem in drei Richtungen schlierenfreien Glas besteht.

Derartiges Glas zeichnet sich durch besonders hohe Homogenität der Dotierstoffverteilung und durch weitgehende Blasenfreiheit aus. Der Volumenanteil V1 dieser aufwändig homogenisierten Glasqualität am erfindungsgemäßen Verbundkörper ist möglichst klein. Ein geeignetes Homogenisierungsverfahren zum Zweck der vollständigen Entfernung von Schlieren und Schichten, und somit zur Herstellung eines in drei Richtungen schlierenfreien Glases, ist in der EP 673 888 A1 beschrieben.

Demgegenüber besteht der Stützkörperbereich vorzugsweise aus einem nur in einer Richtung schlierenfreien Glas.

Derartiges Glas ist preiswerter als ein in drei Richtungen schlierenfreien Glases, da seine Homogenisierung einen geringeren Aufwand erfordert.

Zwecks Einhaltung hoher Qualitätsanforderungen für das Glas in der hochbelasteten Zone bei möglichst geringen Materialkosten für den Spiegelsubstrat-Rohling besteht der Frontkörperbereich vorzugsweise aus Glas, das nach DIN 58927 2/70 die Anforderungen der Blasenklasse 2 oder besser erfüllt, wohingegen der Stützkörperbereich aus Glas besteht, das nach DIN 58927 2/70 die Anforderungen der Blasenklasse 2 oder schlechter erfüllt.

Die Anforderungen an die Qualität des Stützkörperbereich-Glases hinsichtlich der Blasenfreiheit sind geringer als diejenigen an das Glas des Frontkörperbereichs. Das Glas des Stützkörperbereichs erfüllt bevorzugt lediglich die Anforderungen der Blasenklassen 3 bis 5 oder noch schlechter.

Im Hinblick auf die Einhaltung hoher Qualitätsanforderungen für das Glas in der hochbelasteten Zone bei möglichst geringen Materialkosten für den Spiegelsubstrat-Rohling hat es sich auch bewährt, wenn der Frontkörperbereich aus Glas besteht, das eine Verteilung der Titan-Konzentration aufweist, bei der die maximale Abweichung vom Mittelwert weniger als 1 % beträgt, und wenn der Stützkörperbereich aus Glas besteht, das eine Verteilung der Titan-Konzentration aufweist, bei der die maximale Abweichung vom Mittelwert weniger als 5 % beträgt.

Die Anforderungen an die Qualität des Stützkörperbereich-Glases hinsichtlich der Homogenität der Dotierstoffverteilung sind geringer als diejenigen an das Glas des Frontkörperbereichs. Bei der üblichen Dotierstoff-Konzentration (=TiO₂) von etwa 7 Gew.-% genügt das Glas des Stützkörperbereichs den Anforderungen, wenn die maximale Abweichung von diesem Mittelwert weniger als 0,35 Gew.-% beträgt.

Im Hinblick auf eine stabile Fügeverbindung und eine geringe Verformung beim bestimmungsgemäßen Einsatz des Spiegelsubstrats bestehen Frontkörperbereich und Stützkörperbereich idealerweise aus Glas mit nominal gleicher Zusammensetzung.

Im Hinblick auf eine möglichst fehlerfreie Grenzfläche hat es sich bewährt, wenn Frontkörperbereich und Stützkörperbereich in einer ebenen Kontaktfläche aneinander liegen und miteinander verschmolzen sind.

Dabei können Frontkörperbereich und Stützkörperbereich ähnliche oder gleiche seitliche Abmessungen haben, so dass der Frontkörperbereich eine Seite (Oberseite) des Stützkörperbereichs vollständig überdeckt. Diese Ausführungsform des Rohlings eignet sich besonders für Anwendungen des Spiegelsubstrats mit großer numerischer Apertur, bei denen sich die hochbelastete Zone über einen vergleichsweise großen Flächenbereich erstrecken muss.

Bei einer alternativen und gleichermaßen bevorzugten Ausführungsform des erfindungsgemäßen Rohlings ist der Frontkörperbereich im Stützkörperbereich teilweise eingebettet.

Dabei ist der Frontkörperbereich nicht nur mit seiner dem Stützkörperbereich zugewandten Unterseite in Kontakt mit der Stützkörpermasse, sondern auch mit mindestens einem Teil seiner seitlichen Begrenzungsflächen. Die seitlichen Abmessungen des Frontkörperbereichs sind dabei kleiner als diejenigen des Stützkörperbereichs, so dass sich eine dementsprechend größere Materialkostenersparnis ergibt. Diese Ausführungsform des Rohlings eignet sich besonders für Anwendungen des Spiegelsubstrats mit kleiner numerischer Apertur, bei denen sich die hochbelastete Zone nur über einen relativ kleinen Flächenbereich erstreckt. Zudem ergibt sich durch das Einbetten ein fest gefügter Verbund mit seitlicher Fixierung des Frontkörperbereichs im Stützkörperbereich, bei dem auch bei Schlagbeanspruchung, wie etwa bei der mechanischen Bearbeitung, die Gefahr einer Delamination verringert ist.

Die Ersparnis an Fertigungskosten ist umso größer, je kleiner der Volumenanteil des Frontkörperbereichs am Spiegelsubstrat-Rohling ist. Das Volumen "V1" des Frontkörperbereichs ist daher vorzugsweise so klein wie möglich und nur so groß wie nötig, um eine vollständige Modellierung der Außenkontur im hochbelasteten Bereich des Spiegelsubstrats zu ermöglichen. Aus Sicherheitserwägungen weist der Frontkörperbereich jedoch ein gewisses Übermaß gegenüber dem Mindestmaß auf. Vorteilhafterweise ist das Volumen "V2" mindestens doppelt so groß, besonders bevorzugt mindestens dreimal so groß wie "V1".

### Ausführungsbeispiel

Nachfolgend wird die Erfindung anhand eines Ausführungsbeispiels und einer Zeichnung näher erläutert. Dabei zeigt in schematischer Darstellung
- **Fig. 1**: einen Spiegelsubstrat-Rohling gemäß der Erfindung bestehend aus einem Schweißverbund aus Stützkörper und Frontkörper, mit ange-deuteter Außenkontur des daraus zu fertigenden Spiegelsubstrats in einer Seitenansicht im Schnitt,
- **Fig. 2**: einen ersten Verfahrensschritt zur Herstellung eines Spiegelsubstrat-Rohlings durch Erweichen einer Anordnung von Stützkörper und darauf aufgelegtem Frontkörper in einer Schmelzform,
- **Fig. 3**: die Anordnung gemäß Fig. 2 nach dem Schmelzen,
- **Fig. 4**: den Spiegelsubstrat-Rohling nach Entnahme aus der Schmelzform,
- **Fig. 5**: ein aus dem Spiegelsubstrat-Rohling gemäß Fig. 4 durch mechanische Bearbeitung erzeugtes Spiegelsubstrat in einer Seitenansicht im Schnitt,
- **Fig. 6**: einen ersten Verfahrensschritt zur Herstellung eines Spiegelsubstrat-Rohlings durch Zusammenfügen von stangenförmigem Stützkörper und Frontkörper,
- **Fig. 7**: einen Verbundkörper nach dem Zusammenfügen,
- **Fig. 8**: einen durch Umformen des Verbundkörpers gemäß Fig. 7 erhaltenen Spiegelsubstrat-Rohling, und
- **Fig. 9**: ein aus dem Spiegelsubstrat-Rohling gemäß Fig. 9 durch mechanische Bearbeitung erzeugtes Spiegelsubstrat in einer Seitenansicht im Schnitt.

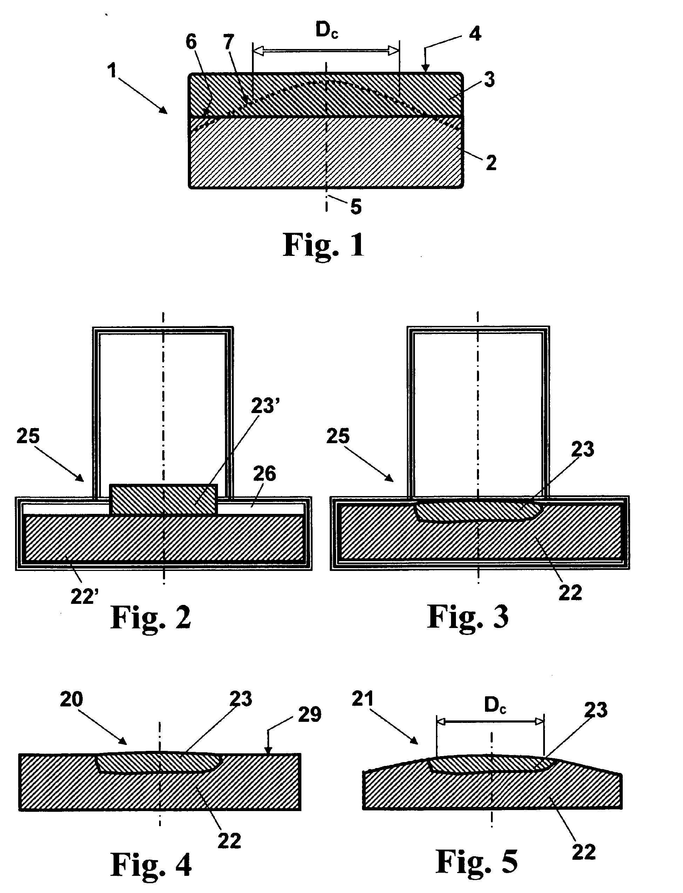

Als Ausgangsmaterial für den in **Fig. 1** schematisch dargestellten Spiegelsubstrat-Rohling 1 wird handelsübliches synthetisches Glas eingesetzt, das mit ca. 7 Gew.-% TiO₂ dotiert ist.

Ein erstes quaderförmiges Auswahlstück dieses Ausgangsmaterials mit den Abmessungen 150 mm x 150 mm x 40 mm dient als Stützkörper 2. Das Glas des Stützkörpers 2 zeigt eine deutlich sichtbare Schichtung in zwei Betrachtungsrichtungen, während die dritte Richtung parallel zur Symmetrieachse 5 im Wesentlichen ohne Schichtstrukturen ist. Die Schichtung beruht auf dem schichtweisen Aufbauprozess bei der Herstellung des Glases.

Das Glas enthält Blasen mit einer Größe von maximal 1,3 mm, wobei die Summe der Blasenquerschnitte weniger als 2 mm² beträgt (bezogen auf ein Volumen von 100 cm³). Das Glas erfüllt die Anforderungen der Blasenklasse 5 gemäß DIN 58927 2/70. Die Verteilung der Titan-Konzentration - gemessen anhand der thermischen Ausdehnung, wie aus der DE 10 2004 024 808 bekannt - ist gekennzeichnet durch eine maximale Abweichung von weniger als 5 % vom nominalen Mittelwert der Dotierstoff-Konzentration (7 Gew.-%).

Eine der Stirnseiten (Oberseite) des Stützkörpers 2 wird zu einer planen Fläche poliert.

Im Folgenden wird die Herstellung eines Frontkörpers 3 durch zusätzliches Homogenisieren eines anderen ausgewählten Probestücks des gleichen Ausgangsmaterials mit geringem Blasengehalt beschrieben. Dieses liegt als stangenförmiger Ausgangskörper mit den Abmessungen 90 mm x 90 mm x 500 mm vor. Die stirnseitigen Endbereiche des Ausgangskörpers werden rund geschliffen und an jedem Ende eine Glas-Halterung angeschweißt, die jeweils auch aus Titan-dotiertem Glas bestehen, so dass die Ausdehnungsverhalten der Halterungen und Ausgangskörper ähnlich sind. Der so verlängerte Ausgangskörper wird in eine mit einem Heizbrenner ausgestattete Drillbank eingespannt und anhand eines Umformprozesses homogenisiert, wie er in der EP 673 888 A1 zum Zweck der vollständigen Entfernung von Schichten beschrieben ist. Dabei wird der Ausgangskörper mittels des Heizbrenners lokal auf über 2000 °C erhitzt und dabei erweicht. Der Ausgangskörper wird durch Relativbewegung der beiden Halterungen zueinander um seine Längsachse verdrillt, wobei die erweichte Glasmasse unter Bildung eines Drillkörpers in radialer Richtung intensiv durchmischt wird. Der Drillkörper hat einen Durchmesser von etwa 90 mm und eine Länge von etwa 635 mm.

Dadurch werden Inhomogenitäten oder Schichten des Ausgangskörpers in radialer Richtung entfernt, wohingegen Inhomogenitäten, die sich in Längsrichtung des Ausgangskörpers erstrecken, als Schlieren oder Schichten erhalten bleiben. Um auch diese zu beseitigen, erfolgt ein weiterer Umformprozess. Dabei wird der Ausgangskörper in eine Schmelzform aus Grafit gestellt, die einen Boden mit rechteckigem Querschnitt und seitlichen Abmessungen von 150 mm x 150 mm aufweist. Zum Verformen wird die gesamte Schmelzform mit dem darin befindlichen des Ausgangskörper zunächst auf 1350 °C und anschließend mit einer Rampe 9 °C/min auf 1700 °C aufgeheizt und danach mit einer Rampe von 2 °C/min auf eine Temperatur von 1780 °C. Bei dieser Temperatur wird die Glasmasse so lange gehalten, bis das erweichte Glas unter Wirkung seines eigenen Gewichts in den Boden der Schmelzform ausgeflossen ist und diese dabei aufgefüllt hat. Aus dem Ausgangskörper wird so eine rechteckige Platte mit Abmessungen von 150 mm x 150 mm x 180 mm geformt, die in allen drei Betrachtungsrichtungen schichten- und schlierenfrei ist. Außerdem wird durch das Homogenisieren eine besonders gleichmäßige Verteilung der im Glas enthaltenen Komponenten, wie etwa Wasserstoff, Hydroxylgruppen und des Dotierstoffs über das gesamte Volumen erreicht.

Das so homogenisierte Glas ist in drei Richtungen schlierenfrei, hat Blasen mit einer Größe von maximal 0,1 mm, wobei die Summe der Blasenquerschnitte weniger als 0,03 mm² beträgt (bezogen auf ein Volumen von 100 cm³). Das Glas erfüllt die Anforderungen der Blasenklasse 0 gemäß DIN 58927 2/70. Die Verteilung der Titan-Konzentration - gemessen anhand der thermischen Ausdehnung, wie aus der DE 10 2004 024 808 bekannt - ist gekennzeichnet durch eine maximale Abweichung von weniger als 1 % vom nominalen Mittelwert (7 Gew.-% TiO₂).

Die Platte aus besonders hochwertigem, homogenisiertem, synthetischem und mit TiO₂ dotiertem Glas wird in insgesamt sechs Platten mit Abmessungen von 150 mm x 150 mm x 30 mm zersägt. Die drei in Bezug auf Blasenfreiheit besten Platten werden ausgewählt und zu scheibenförmigen Frontkörpern 3 verarbeitet, indem jeweils eine der Planseiten poliert wird.

### Beispiel 1

Stützkörper 2 und Frontkörper 3 werden mit ihren polierten Planseiten optisch angesprengt, so dass sich eine auf Anziehungskräften beruhende, blasenfreie Fügeverbindung ergibt. Dieser Fügeverbund wird in einem Ofen auf eine Temperatur von 1650 °C während einer Dauer von 15 min erhitzt. Dadurch wird ein Schmelzverbundkörper mit blasenarmer Kontaktfläche erhalten.

Dieser wird zur Beseitigung mechanischer Spannungen anschließend unter Bildung eines Spiegelsubstrat-Rohlings 1 im Sinne der vorliegenden Erfindung getempert. Das Temperaturprofil beim Tempern des Schmelzverbundkörpers ist wie folgt: Aufheizen auf eine Temperatur von 1175 °C, Halten bei der dieser Temperatur während einer Haltezeit von 10 h; Abkühlen mit einer Abkühlrate von 4°C/h auf eine Temperatur von 950 °C und Halten bei dieser Temperatur während einer Dauer von 12 h, anschließendes freies Abkühlen auf Raumtemperatur.

Der so erzeugte Spiegelsubstrat-Rohling 1 ist in Fig. 1 schematisch dargestellt. Er ist aus Komponenten unterschiedlicher Glasqualitäten zusammengesetzt, nämlich dem Frontkörper 3 und dem Stützkörper 2. Diese sind über eine im Wesentlichen ebene und plane Kontaktfläche 6 miteinander verbunden. Das Volumen des Frontkörpers 3 macht dabei etwa 33 % des Gesamtvolumens des Spiegelsubstrat-Rohlings aus.

Der Spiegelsubstrat-Rohling 1 dient zur Herstellung eines Spiegelsubstrats aus Titan-dotiertem Glas für den Einsatz in der EUV-Lithographie. Zur Herstellung des Spiegelsubstrats wird die vom Frontkörper 3 gebildete Oberseite 4 des Spiegelsubstrat-Rohlings 1, die beim bestimmungsgemäßen Einsatz der EUV-Strahlung zugewandt ist, einer mechanischen Bearbeitung unterzogen, die Schleifen und Polieren umfasst. Dabei wird die Kontur des Spiegels als konvex gekrümmter Oberflächenbereich 7 erzeugt, der in Fig. 1 als punktierte Linie erkennbar ist, und von dem eine kreisförmige Teilfläche mit dem Durchmesser D_{c} als hochbelasteter Oberflächenbereich mit besonders hohen Anforderungen an die Qualität der Oberfläche und an die Homogenität des Glases spezifiziert ist ("hochspezifizierter Volumenanteil"). Die Oberfläche in diesem Bereich (D_{c}) wird ausschließlich vom Frontkörper 3 gebildet, der darüber hinaus noch ein gewisses Übermaß hat. Ein Teil der gekrümmten Oberflächenkontur 7, der geringeren Anforderungen an die Oberflächenqualität unterliegt, zieht sich bis in den Bereich des vom Stützkörper bereitgestellten Glases.

### Beispiel 2

Anhand der **Figuren 2 bis 5** werden eine weitere Ausführungsform des erfindungsgemäßen Spiegelsubstrat-Rohlings und eine weitere Methode zur Herstellung erläutert.

Es wird ein Stützkörper 22' aus einem handelsüblichen, mit Titan dotiertem Glas wird in Form eines Vollzylinders mit kreisförmigen Querschnitt mit einem Durchmesser von 200 mm und einer Höhe von 60 mm bereitgestellt. Das Glas des Stützkörpers 22' hat die anhand Beispiel 1 beschriebene Qualität hinsichtlich Blasenfreiheit, Dotierstoffverteilung und Schlierenfreiheit. Die obere Stirnseite des Stützkörpers 22' wird poliert.

In einem separaten Verfahren wird ein Frontkörper 23' in Form einer runden Scheibe aus besonders hochwertigem, homogenisiertem, synthetischem und mit TiO₂ dotiertem Glas bereitgestellt. Das Glas des Frontkörpers 23' hat die anhand Beispiel 1 beschriebene Qualität hinsichtlich Blasenfreiheit, Dotierstoffverteilung und Schlierenfreiheit. Der scheibenförmige Frontkörper 23' hat einen Durchmesser von 150 mm und eine Dicke von 30 mm, wobei die eine Planseite poliert ist.

Stützkörper 22' und Frontkörper 23' werden mit ihren Planseiten aufeinander gesprengt und durch leichtes lokales Erhitzen zueinander fixiert. Der Frontkörper 23' deckt dabei lediglich den zentralen Bereich der polierten Stützkörper-Stirnseite ab.

Fig. 2 zeigt, dass der Verbund 22', 23' in einen Ofen mit einer Schmelzform 25 aus Grafit eingebracht wird, die einen Bodenbereich 26 mit rundem Querschnitt mit einem Durchmesser von 210 mm und eine Höhe von 70 mm aufweist. Die Schmelzform 25 wird auf 1350 °C und anschließend mit einer Rampe 9 °C/min auf 1700 °C aufgeheizt und danach mit einer Rampe von 2 °C/min auf eine Temperatur von 1780 °C. Bei dieser Temperatur wird die Glasmasse unter Vakuum erweicht. Das erweichte Glas verformt sich unter seinem eigenen Gewicht und füllt den Boden 26 der Schmelzform 25 vollständig auf. Dabei erfährt sowohl das Glas des Stützkörpers 22' aufgrund des auf ihm lastenden Gewichts als auch das Glas des aufliegenden Frontkörpers 23' eine gewisse Verformung durch Ausfließen in lateraler Richtung. Gleichzeitig sinkt das Glas des Frontkörpers 23' in den Stützkörper 22' fast vollständig (etwa 25 mm tief) ein, wie dies in **Fig. 3** schematisch dargestellt ist. Das Glas des Frontkörpers 23' bildet eine Frontkörpermasse 23, die in eine Stützkörpermasse 22 eingebettet ist.

Auf diese Weise wird die in **Fig. 4** gezeigte runde Verbundplatte 20 mit einem Durchmesser von 210 mm und einer Dicke von etwa 70 mm erhalten, die sich aus zwei miteinander verschmolzenen Massen 22, 23 unterschiedlicher Glasqualitäten zusammensetzt. Die Stützkörpermasse 22 entspricht im Wesentlichen handelsüblicher Qualität, wobei sich durch den beschriebenen Umformprozess eine gewisse zusätzliche Homogenisierung ergibt. Der zentrale Bereich der Stützkörpermasse 22 ist abgedeckt von der Frontkörpermasse 23, die aus höherwertigem Glas besteht, das in allen drei Betrachtungsrichtungen schichten- und schlierenfrei ist, und das sich durch eine besonders gleichmäßige Verteilung der im Glas enthaltenen Komponenten, wie etwa Wasserstoff, Hydroxylgruppen und des Dotierstoffs über das gesamte Volumen sowie weitgehende Blasenfreiheit auszeichnet. Die Kontaktfläche zwischen den Massen 22, 23 ist wannenartig ausgeformt, leicht uneben aber im Wesentlichen blasenfrei. Das Volumen der Frontkörpermasse 23 ist etwa um den Faktor 3,5 kleiner als das Volumen der Stützkörperrmasse 22.

Die Verbundplatte 20 wird in üblicher Weise getempert, wie oben anhand Beispiel 1 erläutert. Der so erhaltene Spiegelsubstrat-Rohling 20 dient zur Herstellung eines Spiegelsubstrats 21 aus Titan-dotiertem Glas für den Einsatz in der EUV-Lithographie, wobei der von der Frontkörpermasse 23 abgedeckte Flächenbereich der Oberseite 29 des Spiegelsubstrats 21 der EUV-Strahlung zugewandt ist.

Das beschriebene Verfahren des "Einsackenlassens" des Frontkörpers 23' in die erweichende Stützkörpermasse 22 hat den Vorteil, dass trotz einer gewissen Verformung des Frontkörpers 23' die Endposition und -geometrie der Fronkörpermasse 23 innerhalb des Verbundkörpers/Spiegelsubstrat-Rohlings 20 vergleichsweise genau vorherbestimmt und auch noch während des "Einsackens" beeinflusst werden können. Auf diese Weise wird eine innige und fehlerarme Kontaktfläche erhalten, wobei im Vergleich zum weiter unten anhand Beispiel 3 beschriebenen Verfahren durch eine vergleichsweise geringere Verformung des Formkörpers 23' eine geringere Einsatzmasse für den Frontkörper 23' benötigt wird.

Zur Herstellung des Spiegelsubstrats 21 wird die Oberseite 29 des Spiegelsubstrat-Rohlings 20 einer mechanischen Bearbeitung unterzogen, die Schleifen und Polieren umfasst. Dabei wird ein konvex gekrümmter Oberflächenbereich erzeugt, die in **Fig. 5** gezeigt. Eine kreisförmige Teilfläche mit einem Durchmesser D_{c} von 150 mm ist dabei als hochbelasteter Oberflächenbereich mit besonders hohen Anforderungen an die Qualität der Oberfläche und an die Homogenität des Glases spezifiziert. Dieser Oberflächen- und Volumenbereich wird ausschließlich von der Frontkörpermasse 23 gebildet. Der größte Teil der gekrümmten Oberfläche des Spiegelsubstrats 21, der geringeren Anforderungen an die Oberflächenqualität unterliegt, wird von der Stützkörpermasse 22 gebildet.

Die gekrümmte Oberfläche des Spiegelsubstrat 21 wird mit einer Spiegelschicht versehen und das das erhaltene Spiegelelement wird in einem Projektionssystem für die EUV-Lithographie eingesetzt.

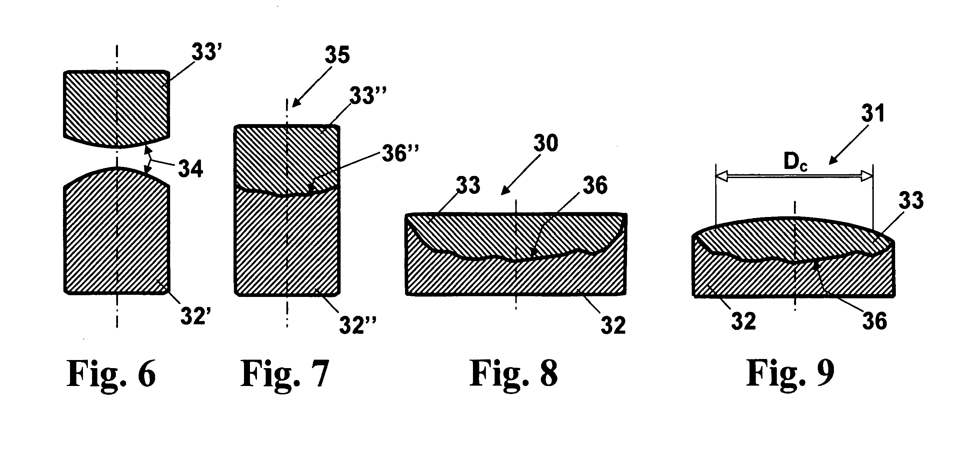

Anhand der **Figuren 6 bis 9** werden eine weitere Ausführungsform des erfindungsgemäßen Spiegelsubstrat-Rohlings und eine weitere Methode zur Herstellung desselben erläutert.

### Beispiel 3

**Fig. 6** zeigt schematisch einen ersten Zylinder 33' aus Titan-dotiertem Glas mit einer hohen Qualität hinsichtlich Blasenfreiheit, Dotierstoffverteilung und Schlierenfreiheit, sowie einen zweiten Zylinder 32' aus handelsüblichem, mit 7 Gew.-% Titan dotiertem Glas einer geringeren Qualität hinsichtlich Blasenfreiheit, Dotierstoffverteilung und Schlierenfreiheit (wie jeweils oben anhand Beispiel 1 erläutert).

Die Außendurchmesser der Zylinder 32', 33' beträgt jeweils 80 mm und jeweils eine Stirnseite 34 beider Zylinder 32', 33' ist in Kegelform mit abgerundeter Kegelspitze geschliffen.

Die Zylinder 32', 33' werden in die Drehfutter eine Drehbank eingespannt und auf eine gemeinsame Mittel- und Rotationsachse justiert. Anschließend werden die spitzen Stirnseiten 34 der Zylinder 32', 33' stoßweise gegeneinander geführt und gleichzeitig im Kontaktbereich unter Rotation erhitzt und miteinander verschmolzen. Wegen der Temperaturführung beim Verschmelzen wird dabei das Glas des zweiten Zylinders 32' geringfügig weicher als das Glas des ersten Zylinders 33', so dass es sich etwas stärker verformt.

Auf diese Weise wird ein im Wesentlichen zylinderförmiger Schmelzverbundkörper 35 mit einem Außendurchmesser von etwa 80 mm und einer Länge von etwa 1000 mm erzeugt, der schematisch in **Fig. 7** dargestellt ist. Dieser setzt sich aus zwei miteinander verschmolzenen Glasmassen 32", 33" unterschiedlicher Qualitäten zusammen, die in einem Kontaktbereich 36" miteinander verschmolzen sind.

Der Schmelzverbundkörper 35 wird einem Umformprozess in einer Schmelzform unterzogen, wie anhand Beispiel 2 beschrieben. Dabei kommt es zu einer weiteren Verformung der miteinander verschmolzenen Glasmassen 32", 33", einhergehend mit einer Reduzierung noch vorhandener Schichten oder Blasen und einer weiteren Homogenisierung der Dotierstoffverteilung.

Es wird der in **Fig. 8** dargestellte Spiegelsubstrat-Rohling 30 mit einem Außendurchmesser von 300 mm und einer Höhe von 71 mm erhalten. Das Volumen der Frontkörpermasse 33 deckt die Stützkörpermasse 32 nach oben hin vollständig ab und macht etwa 40 % des Gesamtvolumens des Rohlings 30 aus. Die Kontaktfläche 36 zwischen den Glasmassen 32, 33 ist zwar uneben und wellig, jedoch im Wesentlichen frei von Blasen.

Der Spiegelsubstrat-Rohling 30 wird anhand des in Beispiel 1 beschrieben Verfahrens getempert und anschließend einer mechanischen Endbearbeitung zur Herstellung des in **Fig. 9** gezeigten Spiegelsubstrats 31 mit einem Außendurchmesser von 280 mm unterzogen. Dabei wird ein konvex gekrümmter Oberflächenbereich erzeugt, von dem eine kreisförmige Teilfläche mit einem Durchmesser D_{c} von 260 mm als hochbelasteter Oberflächenbereich mit besonders hohen Anforderungen an die Qualität der Oberfläche und an die Homogenität des Glases spezifiziert ist. Dieser Oberflächen- und Volumenbereich wird ausschließlich von der Frontkörpermasse 33 gebildet. Der größte Teil des Volumens des Spiegelsubstrat-Rohlings 30 beziehungsweise des daraus erhaltenen Spiegelsubstrats 31 wird jedoch von der kostengünstigeren Stützkörpermasse 32 gebildet.

Die gekrümmte Oberfläche des Spiegelsubstrats 31 wird mit einer Spiegelschicht versehen und das das erhaltene Spiegelelement wird in einem Projektionssystem für die EUV-Lithographie eingesetzt.

## Patentansprüche

1. Verfahren zur Herstellung eines Rohlings (1; 20; 30) aus Titan-dotiertem, hochkieselsäurehaltigem Glas für ein Spiegelsubstrat (21; 31) für den Einsatz in der EUV-Lithographie, das einen zu verspiegelnden und beim bestimmungsgemäßen Einsatz des Spiegelsubstrats (21; 31) als hochbelastete Zone spezifizierten Oberflächenbereich (D_{c}) aufweist, der eine Außenkontur hat, umfassend folgende Verfahrensschritte:
(a) Erzeugen eines Frontkörpers (3; 23'; 33') aus Titan-dotiertem Glas hoher Homogenität mit einem Volumen "V1" und mit Abmessungen, die die Außenkontur mit Übermaß umschließen,
(b) Erzeugen eines Stützkörpers (2; 22'; 32') aus Titan-dotiertem Glas mit einem Volumen "V2", der als monolithischer Glasblock mit geringerer Homogenität als der Frontkörper (3; 23', 33') ausgebildet ist,
(c) Verbinden von Frontkörper (3; 23'; 33') und Stützkörper (2; 22'; 32') unter Bildung eines Verbundkörpers, und
(d) Bearbeitung des Verbundkörpers zum Spiegelsubstrat-Rohling (1; 20; 30),
wobei das Erzeugen des Frontkörpers (3; 23'; 33') einen Homogenisierungsprozess umfasst, der ein Verdrillen eines durch Flammenhydrolyse einer siliziumhaltigen Verbindung erhaltenen stangenförmigen Ausgangskörpers aus Titan-dotiertem Glas zu einem Frontkörperrohling umfasst, wobei der Ausgangskörper beim Umformen zwischen zwei Halterungen gehalten, zonenweise auf Schmelztemperatur gebracht und dabei die erhitzte Zone durch Relativbewegung der beiden Halterungen zueinander unter Ausbildung eines im Wesentlichen zylinderförmigen Drillkörpers durchgearbeitet wird.

2. Verfahren nach Anspruch 1, **dadurch gekennzeichnet, dass** der zylinderförmige Drillkörper einem weiteren Homogenisierungsprozess durch Verdrillen unterzogen und zu einem in drei Richtungen homogenisierten Drillkörper umgeformt wird.

3. Verfahren nach Anspruch 1 oder 2, **dadurch gekennzeichnet**, das Erzeugen des Frontkörpers (3; 23'; 33') ein Umformen eines zylinderförmigen Ausgangskörpers durch Erweichen und Ausfließenlassen in eine beheizte Form umfasst, in die das Glas des Ausgangskörpers unter Einwirkung einer Kraft in Querrichtung zur Zylinderlängsachse unter Bildung eines homogenisierten Ausgangskörpers ausfließt.

4. Verfahren nach einem der vorhergehenden Ansprüche, **dadurch gekennzeichnet, dass** mindestens ein Frontkörper (3; 23'; 33'), vorzugsweise mehrere Frontkörper (3; 23'; 33') durch Schneiden aus dem Drillkörper beziehungsweise aus dem homogenisierten Drillkörper beziehungsweise aus dem homogenisierten Ausgangskörper erhalten werden.

5. Verfahren nach einem der vorhergehenden Ansprüche, **dadurch gekennzeichnet, dass** das Erzeugen des Frontkörpers (3; 23'; 33') die Herstellung einer Vorform aus synthetischem Glas sowie einen Verfahrensschritt der Selektion umfasst, bei dem aus der Vorform ein Teilstück ausgewählt und daraus der Frontkörper (3; 23'; 33') ausgeschnitten wird.

6. Verfahren nach einem der vorhergehenden Ansprüche, **dadurch gekennzeichnet, dass** das Erzeugen des Stützkörpers (2; 22'; 32') ein Homogenisieren eines durch Flammenhydrolyse einer siliziumhaltigen Verbindung erhaltenen stangenförmigen Stützkörper-Ausgangskörper zu einem Drillkörper umfasst, wobei der Stützkörper-Ausgangskörper beim Umformen zwischen zwei Halterungen gehalten, zonenweise auf Schmelztemperatur gebracht und dabei die erhitzte Zone durch Relativbewegung der beiden Halterungen zueinander unter Ausbildung eines im Wesentlichen zylinderförmigen Drillkörpers durchgearbeitet wird, wobei der Stützkörper (2; 22'; 32') aus dem Glas des Drillkörpers erhalten wird.

7. Verfahren nach einem der vorhergehenden Ansprüche, **dadurch gekennzeichnet, dass** das Verbinden gemäß Verfahrensschritt (c) einen Verbindungsschritt umfasst, bei dem eine plane Kontaktfläche (6) des Frontkörpers (3) und eine plane Kontaktfläche (6) des Stützkörpers (2) durch Ansprengen zusammengefügt und miteinander verschweißt werden.

8. Verfahren nach einem der Ansprüche 1 bis 7, **dadurch gekennzeichnet, dass** das Verbinden gemäß Verfahrensschritt (c) einen Verbindungsschritt umfasst, bei dem der auf dem Stützkörper (22') aufliegende Frontkörper (23') in einem Ofen (25) erweicht und mit diesem zusammen verformt wird und dabei mindestens teilweise in den Stützkörper (22') einsinkt.

9. Verfahren nach einem der Ansprüche 1 bis 7, **dadurch gekennzeichnet, dass** das Verbinden gemäß Verfahrensschritt (c) einen Verbindungsschritt umfasst, bei dem eine Kontaktfläche (34) des Frontkörpers (33') und eine Kontaktfläche (34) des Stützkörpers (32') erweicht und gegeneinander gepresst werden, wobei mindestens eine der Kontaktflächen (34) eine nach außen gewölbte Oberfläche hat.

10. Rohling aus Titan-dotiertem, hochkieselsäurehaltigem Glas für ein Spiegelsubstrat (21; 31) für den Einsatz in der EUV-Lithographie, das einen zu verspiegelnden und beim bestimmungsgemäßen Einsatz des Spiegelsubstrats (21; 31) als hochbelastete Zone spezifizierten Oberflächenbereich (D_{c}) aufweist, der eine Außenkontur hat, **dadurch gekennzeichnet, dass** der Rohling (1; 20; 30) als Schmelzverbundkörper vorliegt, der einen Frontkörperbereich (3; 23; 33) aus Titan-dotiertem Glas hoher Homogenität mit einem Volumen "V1" und mit Abmessungen, die die Außenkontur mit Übermaß umschließen, sowie einen Stützkörperbereich (2; 22; 32) aus Titan-dotiertem Glas mit einem Volumen "V2" umfasst, wobei der Stützkörperbereich (2; 22'; 32') als monolithischer Glasblock mit geringerer Homogenität als der Frontkörperbereich (3; 23; 33) ausgebildet ist.

11. Rohling nach Anspruch 10, **dadurch gekennzeichnet, dass** der Frontkörperbereich (3, 23; 33) aus einem in drei Richtungen schlierenfreien Glas und der der Stützkörperbereich (2; 22; 32) aus einem in einer Richtung schlierenfreien Glas besteht.

12. Rohling nach einem der Ansprüche 10 oder 11, **dadurch gekennzeichnet, dass** der Frontkörperbereich (3; 23; 33) aus Glas besteht, das nach DIN 58927 2/70 die Anforderungen der Blasenklasse 2 oder besser erfülltund dass der Stützkörperbereich (2; 22; 32) aus Glas besteht, das nach DIN 58927 2/70 die Anforderungen der Blasenklasse 2 oder schlechter erfüllt.

13. Rohling nach einem der Ansprüche 10 bis 12, **dadurch gekennzeichnet, dass** der Frontkörperbereich (3; 23; 33) aus Glas besteht, das eine Verteilung der Titan-Konzentration aufweist, bei der die maximale Abweichung vom Mittelwert weniger als 1 % beträgt und dass der Stützkörperbereich (2; 22; 32) aus Glas besteht, das eine Verteilung der Titan-Konzentration aufweist, bei der die maximale Abweichung vom Mittelwert weniger als 5 % beträgt.

14. Rohling nach einem der Ansprüche 10 bis 13, **dadurch gekennzeichnet, dass** der Frontkörperbereich (§; 23; 33) im Stützkörperbereich (2; 22; 32) teilweise eingebettet ist.

15. Rohling nach einem der Ansprüche 10 bis 14, **dadurch gekennzeichnet, dass** Frontkörperbereich (3; 23; 33) und Stützkörperbereich (2; 22; 32) aus Glas mit nominal gleicher Zusammensetzung bestehen.

16. Rohling nach einem der Ansprüche 10 bis 15, **dadurch gekennzeichnet, dass** "V2" mindestens doppelt so groß, vorzugsweise mindestens dreimal so groß ist, wie "V1.

## Claims

1. A method for producing a blank (1; 20; 30) of titanium-doped, highly siliceous glass for a mirror substrate (21; 31) for use in EUV lithography, said blank has a surface area (D_{c}) that has an outer contour being designated to be metalized, said surface area is specified as a highly stressed zone during the intended use of the mirror substrate (21; 31), the method comprising the following steps:
(a) producing a front body (3; 23'; 33') of titanium-doped glass of high homogeneity with a volume "V1" and with dimensions enclosing the outer contour with an oversize;
(b) producing a support body (2; 22'; 33') of titanium-doped quartz glass with a volume "V2", the support body being configured as a monolithic glass block of lower homogeneity than the front body (3; 23'; 33");
(c) joining front body (3; 23'; 33') and support body (2; 22'; 32') so as to form a composite body; and
(d) treating the composite body to obtain the mirror substrate blank (1; 20; 30), wherein the production of the front body (3; 23'; 33') includes a homogenizing process which comprises the twisting of a rod-shaped start body of titanium-doped glass obtained by flame hydrolysis of a silicon-containing compound to form a front body blank, wherein the start body is held during the shaping process between two holders, is zonewise heated to melting temperature and the heated zone is thereby worked by relative movement of the two holders to each other so as to form a substantially cylindrical twist body.

2. The method according to claim 1, **characterized in that** the cylindrical twist body is subjected to a further homogenizing process by twisting and is shaped into a twist body homogenized in three directions.

3. The method according claim 1 or 2, **characterized in that** the production of the front body (3; 23'; 33') comprises a shaping of a cylindrical start body by softening and letting said body flow out into a heated mold into which the quartz glass of the start body flows out under the action of a force in a transverse direction relative to the longitudinal axis of the cylinder so as to form a homogenized start body.

4. The method according to any one of the preceding claims, **characterized in that** at least one front body (3; 23'; 33'), preferably a plurality of front bodies (3; 23'; 33'), are obtained by cutting from the twist body or from the homogenized twist body, respectively, or from the homogenized start body, respectively.

5. The method according to any one of the preceding claims, **characterized in that** the production of the front body (3; 23'; 33') comprises the manufacture of a preform of synthetic quartz glass and a selecting method step in which a section is selected from the preform, and the front body (3; 23'; 33') is cut out therefrom.

6. The method according to any one of the preceding claims, **characterized in that** the production of the support body (2; 22' 32') comprises homogenizing a rod-shaped support body/start body obtained by flame hydrolysis of a silicon-containing compound into a twist body, wherein the support body/start body is held between two holders during shaping, is zonewise heated to melting temperature and the heated zone is thereby worked by relative movement of the two holders relative to each other so as to form a substantially cylindrical twist body, with the support body (2; 22'; 32') being obtained from the quartz glass of the twist body.

7. The method according to any one of the preceding claims, **characterized in that** the joining process according to method step (c) comprises a joining step in which a plane contact surface (6) of the front body (3) and a plane contact surface (6) of the support body (2) are joined by optical contacting and are welded to each other.

8. The method according to any one of claims 1 to 7, **characterized in that** the joining process according to method step (c) comprises a joining step in which the front body (23') positioned on the support body (22') is softened in a furnace (25) and deformed together with said support body and immerses at least in part into the support body (22') in said process.

9. The method according to any one of claims 1 to 7, **characterized in that** the joining process according to method step (c) comprises a joining step in which a contact surface (34) of the front body (33') and a contact surface (34) of the support body (32') are softened and pressed against each other, with at least one of the contact surfaces (34) having an outwardly curved surface.

10. A blank consisting of titanium-doped, highly siliceous glass for a mirror substrate (21; 31) for use in EUV lithography, comprising a surface area (D_{c}) which has an outer contour and which is designated to be metalized and which is specified as a highly stressed zone during the intended use of the mirror substrate (21; 31), **characterized in that** the blank (1; 20; 30) is present as a melt composite body having a front body portion (3; 23; 33) of titanium-doped glass of high homogeneity with a volume "V1" and with dimensions enclosing the outer contour with an oversize, and a support body portion (2; 22; 32) of titanium-doped quartz glass with a volume "V2", the support body portion (2; 22'; 32') being configured as a monolithic glass block of lower homogeneity than the front body portion (3; 23; 33).

11. The blank according to claim 10, **characterized in that** the front body portion (3; 23; 33) consists of a glass that is without striae in three directions, and the support body portion (2; 22; 32) consists of glass that is without striae in one direction.

12. The blank according to any one of claims 10 to 11, **characterized in that** the front body portion (3; 23; 33) consists of glass that in conformity with DIN 58927 2/70 meets the demands of Bubble Class 2 or better, and the support body portion (2; 22; 32) consists of glass that in conformity with DIN 58927 2/70 meets the demands of Bubble Class 2 or worse.

13. The blank according to any one of claims 10 to 12, **characterized in that** the front body portion (3; 23; 33) consists of glass that shows a distribution of the titanium concentration at which the maximum deviation from the mean value is less than 1%, and the support body portion (2; 23; 32) consists of glass that shows a distribution of the titanium concentration at which the maximum deviation from the mean value is less than 5%.

14. The blank according to any one of claims 10 to 13, **characterized in that** the front body portion (3; 23; 33) is partly embedded in the support body portion (2; 22; 32).

15. The blank according to any one of claims 10 to 14, **characterized in that** front body portion (3; 23; 33) and support body portion (2; 22; 32) consist of glass with nominally identical composition.

16. The blank according to any one of claims 10 to 15, **characterized in that** "V2" is at least twice as large, preferably at least three times as large, as "V1".

## Revendications

1. Procédé pour la fabrication d'une ébauche (1 ; 20 ; 30) en verre doté au titane avec une haute teneur en acide silique pour un substrat miroir (21, 31) pour l'emploi en lithographie EUV qui présente une région (D_{c}) de surface spécifiée comme zone fortement sollicitée lors de l'emploi conforme à la destination du substrat miroir (21 ; 31) qui présente un contour externe comprenant les étapes de procédé suivantes :
(a) génération d'un corps frontal (3, 23 ; 33') en verre dopé au titane d'homogénéité élevée avec un volume "V1" et avec des dimensions, qui entourent le contour externe avec des sur-dimensions qui entourent le contour externe en débordant,
(b) génération d'un corps de soutien (2, 22' ; 32') en verre dopé au titane d'homogénéité avec un volume "V2" qui est réalisé comme bloc de verre monolithique avec une homogénéité inférieure à celle du corps frontal (3; 23', 33'),
(c) liaison du corps frontal (3; 23'; 33') et du corps de soutien (2, 22' ; 32') en formant un corps composite, et
(d) traitement du corps composite pour obtenir une ébauche de substrat
miroir (1 ; 20 ; 30) ;
la génération du corps frontal (3 ; 23' ; 33') comprenant un processus d'homogénéisation qui comporte un tordage d'un corps de sortie en forme de barre obtenue par hydrolyse à la flamme d'une liaison contenant du silicium en forme de barre en verre dopé au titane en une ébauche de corps frontal, le corps de sortie étant maintenu lors de la transformation entre deux fixations, par zone à la température de fusion et la zone chauffée étant finie par le mouvement relatif des deux fixations entre elles par formation d'un corps de torsion sensiblement en forme de cylindre.

2. Procédé selon la revendication 1, **caractérisé en ce que** le corps de torsion en forme de cylindre est soumis à un autre processus d'homogénéisation par torsion et est transformé en un corps de torsion homogénéisé dans trois directions.

3. Procédé selon la revendication 1 ou 2, **caractérisé en ce que** la génération de corps frontal (3 ; 23' ; 33') comporte une déformation d'un corps de sortie cylindrique par ramollissement et écoulement dans un moule chauffé, dans lequel le verre du corps initial s'écoule sous l'action d'une force dans la direction transversale de la longueur longitudinale de cylindre en formant un corps initial homogénéisé.

4. Procédé selon l'une des revendications précédentes, **caractérisé en ce qu'**au moins un corps frontal (3; 23'; 33'), de préférence plusieurs corps frontaux (3; 23'; 33') sont obtenus par découpe du corps de torsion, notamment du corps de torsion homogénéisé, notamment du corps initial homogénéisé.

5. Procédé selon l'une des revendications précédentes, **caractérisé en ce que** la génération du corps frontal (3 ; 23' ; 33') comprend la fabrication d'une ébauche en verre synthétique ainsi qu'une étape de procédé de la sélection, à partir de l'ébauche une partie étant sélectionnée et le corps frontal (3 ; 23' ; 33') étant découpé.

6. Procédé selon l'une des revendications précédentes, **caractérisé en ce que** la génération du corps de support (2 ; 22' ; 32) comprend une homogénéisation d'un corps initial de support en forme de barre obtenu par hydrolyse à la flamme d'une liaison contenant du silicium, en un corps de torsion , le corps initial de support étant maintenu entre deux fixations pendant la déformation, étant amené par zone à la température de fusion et la zone chauffée étant travaillée par un mouvement relatif des deux fixations l'une par rapport à l'autre en formant un corps de torsion sensiblement cylindrique, le corps de support (2 ; 22' ; 32) étant obtenu à partir du verre du corps de torsion.

7. Procédé selon l'une des revendications précédentes, **caractérisé en ce que** la liaison comprend une étape de liaison selon l'étape de procédé (c), où une surface plane de contact (6) du corps frontal (3) et une surface de contact plane (6) du corps de support (2) sont assemblées et soudées par accolage.

8. Procédé selon l'une des revendications 1 à 7, **caractérisé en ce que** la liaison comprend une étape de liaison selon l'étape de procédé (c), où le corps frontal (23') appliqué sur le corps de support (22') se ramollie dans un four (25) et est déformé ensemble avec ce dernier et s'affaisse partiellement dans le corps de support (22').

9. Procédé selon l'une des revendications 1 à 7, **caractérisé en ce que** la liaison comprend une étape de liaison selon l'étape de procédé (c), où une surface de contact (34) du corps frontal (33) et une surface de contact (34) du corps de support (32') sont ramollies et sont pressées l'une contre l'autre, au moins une des surfaces de contact (34) présentant une surface bombée vers l'extérieur.

10. Ebauche en verre dopé au titane, en verre doté au titane avec une haute teneur en acide silique pour un substrat miroir (21 ; 31) pour l'emploi en lithographie EUV qui présente une région (D_{c}) de surface spécifiée comme zone fortement sollicitée qui fait preuve d'un emploi conforme à la destination du substrat miroir (21 ; 31) et comprend un contour externe, **caractérisée en ce que** l'ébauche (1 ; 20 ; 30) est sous forme de corps composite de fusion qui comprend une zone de corps frontal (3 ; 23 ; 33) en verre dopé au titane d'homogénéité élevée avec un volume "V1" et de dimensions qui entourent le contour externe en débordement, ainsi une zone de corps de support (2 ; 22 ; 32) en verre dopé au titane avec un volume "V2", la zone de corps de support (2 ; 22' ; 32) étant réalisée comme bloc de verre monolithique avec une homogénéité plus faible que la zone de corps frontal (3 ; 23 ; 33).

11. Ebauche selon la revendication 10, **caractérisée en ce que** la zone de corps frontal (3 ; 23' ; 33') se compose d'un verre sans strie dans les trois directions et la zone du corps de support (2 ; 22' ; 32) se compose d'un verre sans stries dans une direction.

12. Ebauche selon la revendication 10 ou 11, **caractérisée en ce que** la zone de corps frontal (3 ; 23' ; 33') se compose d'un verre qui répond aux exigences de la norme DIN 58927 2/70 de la classe de bulle 2 ou les surpasse et **en ce que** la zone du corps de support (2 ; 22' ; 32) se compose de verre qui répond selon la norme 58927 2/70 aux exigences de la classe de bulles 2 ou est inférieure aux exigences.

13. Ebauche selon l'une des revendications 10 à 12, **caractérisée en ce que** la zone de corps frontal (3 ; 23' ; 33') se compose de verre qui présente une répartition de la concentration titane où la divergence maximale par rapport à la valeur moyenne est inférieure à 1 % et **en ce que** la zone de corps de support (2 ; 22' ; 32) se compose de verre qui présente une répartition de la concentration titane où la divergence maximale par rapport à la valeur moyenne est inférieure à 5 %.

14. Ebauche selon l'une des revendications 10 à 13, **caractérisée en ce que** la zone de corps frontal (3 ; 23' ; 33') est enrobée partiellement dans la zone de corps de support (2 ; 22' ; 32).

15. Ebauche selon l'une des revendications 10 à 14, **caractérisée en ce que** la zone de corps frontal (3 ; 23' ; 33') et la zone de corps de support (2 ; 22' ; 32) se compose de verre avec une composition nominalement identique.

16. Ebauche selon l'une des revendications 10 à 15, **caractérisée en ce que** "V2" est au moins deux fois plus important de préférence trois fois plus important que "V1".
